# EUROPÄISCHE PATENTSCHRIFT

(11) **EP 0 865 512 B1**
(45) Veröffentlichungstag und Bekanntmachung des Hinweises auf die Patenterteilung: **28.04.1999**
(21) Anmeldenummer: 96943015.6
(22) Anmeldetag: 05.12.1996
(51) Int. Cl.: C23C 14/26

(54) **VERFAHREN UND VERDAMPFERSCHIFFCHEN ZUM VERDAMPFEN VON METALL**
METAL-VAPORIZING METHODS AND VAPORIZER BOAT THEREFORE
PROCEDES DE VAPORISATION DE METAL ET NACELLE DE VAPORISATION UTILISEE A CETTE FIN

(30) Priorität: 08.12.1995 DE 19545914
(43) Veröffentlichungstag der Anmeldung: 23.09.1998
(73) Patentinhaber: Sintec Keramik GmbH, 87642 Buching (DE)
(72) Erfinder: GOETZ, Ulrich, D-87642 Buching (DE)
(74) Vertreter: Viering, Jentschura & Partner
(86) Internationale Anmeldenummer: DE9602338
(87) Internationale Veröffentlichungsnummer: WO9721847

(56) Entgegenhaltungen:
- US-A- 2 996 412
- US-A- 3 117 887
- US-A- 4 089 643
- XEROX DISCLOSURE JOURNAL, Bd. 1, Nr. 6, Juni 1976, US, Seite 19 XP002028904 F. ERHART: "PREFERENTIALLY HEATED STRUCTURE (CRUCIBLE)"

## Beschreibung

Die Erfindung betrifft ein Verfahren zum Verdampfen von Metall nach dem Oberbegriff des Anspruchs 1, sowie ein keramisches, widerstandsbeheiztes Verdampferschiffchen nach den Oberbegriffen der Ansprüche 3 und 5.
Aus dem Stand der Technik sind allgemein Verfahren zum Verdampfen von Metall sowie entsprechende Verdampferschiffchen bekannt, welche aus einem keramischen, elektrisch leitfähigen Werkstoff hergestellt sind, wozu i. d. R. Titandiborid als leitfähige Phase und Bornitrid bzw. Bornitrid plus Aluminiumnitrid als isolierende Phase verwendet werden. Derartige Verdampferschiffchen sind nach dem Stand der Technik als längliche Stäbe mit einem im wesentlichen rechteckigen, oder quadratischen Querschnitt hergestellt. Typische Querschnitte sind 10 x 20 mm, 10 x 30 mm oder 12 x 19 mm. Typische Längen sind z.B. 150 bis 250 mm. Die Enden der Verdampferschiffchen in Längsrichtung gesehen sind an eine Stromquelle angeschlossen, so daß die Verdampferschiffchen in Längsrichtung homogen von einem bestimmten Stromfluß pro Querschnittsflächeneinheit durchströmt werden und das gesamte Verdampferschiffchen somit als Heizwiderstand reagiert und somit auch relativ homogen aufgeheizt wird. Üblicherweise erfolgt die Kontaktierung der Verdampferschiffchen stirnflächenseitig durch Anpressen von Einspannbacken gegen die Stirnflächen des jeweiligen Verdampferschiffchens. Die Einspannbacken selbst sind in der Regeln mit einem wassergekühlten elektrischen Leiter verbunden, der vorzugsweise aus Kupfer hergestellt ist. Ein typischer spezifischer Widerstand des Keramikmaterials des Verdampferschiffchens kann beispielsweise 800 µΩcm betragen.

Gemäß den herkömmlichen Verdampfungsverfahren wird das zu verdampfende Metall, i. d. R. Aluminium bzw. dessen Legierungen, z. B. in Form eines Drahtes auf das Verdampferschiffchen geführt, wodurch der Schmelzvorgang einsetzt und das Verdampferschiffchen von der Schmelze benetzt wird. Da die Aufheizung aufgrund des im wesentlichen homogenen Widerstands ebenfalls über den Querschnitt des Verdampferschiffchens relativ gleichmäßig erfolgt, erfolgt auch eine in der Breite des Verdampferschiffchens gesehen relativ gleichmäßige Benetzung mit Aluminiumschmelze. Dies führt andererseits auch dazu, daß das Aluminium über die seitlichen Längskanten des Verdampferschiffchens aufgrund der guten Benetzung läuft und somit nicht mehr nach oben gerichtet abgedampft wird, sondern von den seitlichen Flächen in horizontaler Richtung verdampft wird. Übliche Verdampfer sind jedoch so aufgebaut, daß die zu bedampfende Fläche oberhalb der Verdampferschiffchen vorbeigeführt wird, z. B. eine zu bedampfende Kondensatorfolie zum Herstellen von Wickelkondensatoren. Durch das ungewollte, seitliche Abdampfen gelangt das so verdampfte Aluminium jedoch gar nicht oder zumindest nicht vollständig auf die zu bedampfende Kondensatorfolie, sondern schlägt sich an einer anderen Stelle nieder, z. B. irgendwo an der Wand des unter Vakuum stehenden Raumes, in welchem das Verdampferschiffchen und die zu bedampfende Fläche angeordnet sind. Damit ergeben sich große Wartungsprobleme bzgl. des Verdampfers, weil sich nach und nach der Raum mit Aluminiumablagerung zusetzt, welche nur sehr schwierig zu entfernen sind.

Um ein Überlaufen der Aluminiumschmelze über die seitlichen Kanten zu verhindern, hat man im Stand der Technik eine längs des Verdampferschiffchens verlaufende Mulde vorgesehen, die z.B. durch Ausfräsen hergestellt wurde. Damit konnte sich die Aluminiumschmelze innerhalb der Mulde ähnlich einem länglichen Schmelztiegel verteilen. Jedoch hat sich herausgestellt, daß die Schmelze auch über die Ränder der Mulde in Querrichtung lief und schließlich über die seitlichen Kanten herunterlief und dort verdampfte. Umgekehrt war es auch nicht sinnvoll, die in Längsrichtung verlaufende Ausnehmung in dem Verdampferschiffchen beliebig tief zu gestalten, weil sonst der Schmelzenquerschnitt zu groß würde und damit die Prozeßbedingungen in ungewünschter Weise verändert würden, im einzelnen zu viel Strom durch die Schmelze selbst geleitet würde und damit der Keramikwerkstoff, welcher den Heizwiderstand darstellt, bypaßartig umgangen würde. Abgesehen davon brachte das Ausfräsen der Kavität oder Mulde einen erheblichen Herstellungsaufwand mit sich.

Wünschenswert ist neben dem Verhindern eines Überlaufens der Schmelze über die seitlichen Längskanten auch, daß das Verdampferschiffchen relativ geringe Strahlungsverluste aufweist. Dabei muß jedoch gewährleistet bleiben, daß das Verdampferschiffchen eine solche Form beibehält, daß es herstellungstechnisch mit geringem Aufwand herzustellen ist.

Aus der US-A-2996412 ist ein gattungsfremdes, inhomogenes Verdampferschiffchen bekannt, welches nicht vollständig aus keramischem Material besteht. In ein Kohlenstoffsubstrat ist ein mittiger Metallstreifen höherer Leitfähigkeit eingelegt. Aufgrund der höheren Aufheizung des mittigen Metallstreifens soll eine höhere Aufheizung des Mittelbereichs erzielt werden. Dadurch soll die Schmelze längs des Mittelbereichs lokalisiert werden.

Aus der Druckschrift Xerox Disclosure Journal, Bd. 1, Nr. 6, Juni 1976, US, Seite 19, ist ein Rohr bekannt, dessen Oberseite hochreflektiv und dessen Unterseite hochemissiv (schwarz) ist. Aufgrund des unterschiedlichen Abstrahlungverhaltens sollen höhere Temperaturen an der hochemissiven Fläche im Vergleich zu der hochreflektiven Fläche vorliegen. Eine Lokalisierung der Schmelze erfolgt durch das unterschiedliche Abstrahlverhalten auf Ober- und Unterseite nicht und ist auch schon deshalb nicht angestrebt, weil die Schmelze schon rein theoretisch nicht über die Aufnahmewanne in Form eines halbkreisförmigen Rohrquerschnitts seitlich übertreten kann.

Aus der Druckschrift US 3,117,887 ist ganz allgemein ein herkömmliches Keramik-Verdampferschiffchen mit einem Rechteckquerschnitt bekannt.

Aus der Druckschrift E.D. Parent: "Bar Sources in Metallizing" Soc. of Vac Coaters, Proc 21st Annual Technical Conference (1978), S. 8-18, sind herkömmliche, gattungsgemäße Rechteckverdampfer mit einem Höhe zu Breite Verhältnis von 1:3 bekannt. Außerdem sind gattungsgemäße Verdampfer mit einem dreieckförmigen Querschnitt mit undefiniertem Höhe zu Breite-Verhältnis bekannt. Mit einem derartigen dreieckförmigen Querschnitt soll gegenüber dem rechteckförmigen Querschnitt eine Energieeinsparung erzielt werden.

Aus der Druckschrift US-A-4089643 sind Verdampferschiffchen mit dreieckförmigem Querschnitt in Form eines gleichseitigen Dreiecks bekannt, sowie in Form von gleichschenkligen, aber ansonsten im Höhe zu Breite Verhältnis undefinierten Dreiecken bekannt. Mit einem derartigen dreieckförmigen Querschnitt soll gegenüber dem rechteckförmigen Querschnitt eine Energieeinsparung erzielt werden.

Der Erfindung liegt die Aufgabe zugrunde, Verfahren sowie eine Vorrichtung zu schaffen, wodurch eine gleichmäßige Benetzung des Verdampferschiffchens in Längsrichtung erzielt wird und zugleich in Querrichtung keine Schmelze über die Längskanten des Verdampferschiffchens läuft.

Dies wird gemäß der Erfindung durch die Verfahrensschritte im kennzeichnenden Teil des Anspruchs 1 sowie gemäß der Vorrichtungsmerkmale in den Anprüchen 3 und 5 erreicht.

Eine wesentliche Erkenntnis für die Erfindung ist dabei, daß die Aluminiumschmelze in Abhängigkeit von deren Temperatur eine unterschiedliche Benetzungsneigung zeigt, oder in anderen Worten kühlere Flächen weniger leicht mit Aluminiumschmelze benetzt werden als wärmere Flächen. Wenn der spezifische Widerstand des Verdampferschiffchens über den Querschnitt desselben homogen ist, findet im Prinzip eine gleichstarke Erhitzung über den Querschnitt statt. Wird jedoch im Randbereich Wärme abgeleitet, so ist dieser Randbereich um die abgeleitete Wärme kühler. Unterhalb einer gewissen Temperatur, unter die der Rand z. B. abgekühlt werden kann, findet gar keine Benetzung mehr statt. Dadurch wird verhindert, daß Schmelze über die Ränder des Verdampferschiffchens läuft, und andererseits wird dafür gesorgt, daß sich die Schmelze in Längsrichtung des Verdampferschiffchens ausbreitet. Dadurch, daß also Wärme von dem Randbereich der Verdampferschiffchen gezielt abgeleitet wird, kann eine optimale Verteilung der Schmelze auf dem Verdampferschiffchen gezielt hervorgerufen werden, und es können ein seitliches Abdampfen und damit eine höhere Verunreinigungsneigung des gesamten Verdampfers wie auch Energie- und Materialverluste aufgrund ungezielten Abdampfens unterbunden werden.

Gemäß einer bevorzugten Ausführungsform kann das selektive Abführen von Wärme durch Wärmeleitung zusätzlich zum Abstrahlen von Wärme erfolgen, z. B. durch Anschließen eines wärmeleitfähigen Materials an die Randzone des Verdampferschiffchens, um so Wärme aus dieser Randzone abzuleiten, z. B. in das Verdampfergehäuse.

Gemäß der ersten Alternative des erfindungsgemäßen Verdampferschiffchens ist dieses im wesentlichen T-förmig ausgebildet, wobei sozusagen der "Steg" des "T"-förmigen Profils relativ dick und kurz ausgebildet ist, während die oberen "Schenkel" des "T"-förmigen Profils relativ dünnwandig ausgebildet sein können und somit im Randbereich eine Art Kühlrippe darstellen.

Gemäß der zweiten Alternative des erfindungsgemäßen Verdampferschiffchens ist dieses in Form eines flachen Dreiecks ausgebildet, wobei das Verhältnis von Breite zu Höhe wenigstens 2:1 beträgt. Ein besonders vorteilhaftes Verhältnis von Breite zu Höhe ist z. B. 30 mm : 10 mm. Durch ein derartig flaches Dreieck wird erreicht, daß einerseits eine relativ breite Verdampfungsfläche mit einer Breite von 30 mm bereitgestellt werden kann, und überdies das Verhältnis von Oberfläche des Verdampferschiffchens im Verhältnis zu dem davon umschlossenen Volumen in Querrichtung von der Mitte zum Rand hin zunimmt. Abgesehen davon ist der Dreieckquerschnitt durch einfache Sägeschnitte relativ leicht aus einem Blockmaterial herstellbar. Es besteht aufgrund der mit 30 mm relativ breiten Verdampfungsfläche die Möglichkeit, auf eine Kavität zum Lokalisieren der Schmelze auch vollständig zu verzichten. Schließlich ist die Flächensumme der beiden schräg nach unten geneigten "Strahlungs-Verlustflächen" des flachen Dreieckprofils im Vergleich zu der Flächensumme der drei "Strahlungs-Verlustflächen" bei herkömmlichen Rechteckprofilen relativ klein im Vergleich zu der jeweiligen Verdampfungsfläche des Dreieckprofils bzw. Rechteckprofils.

Wie bereits angedeutet, weist das Verdampferschiffchen gemäß einer vorteilhaften Weiterbildung eine vollständig ebene, obere Verdampfungsfläche auf. In anderen Worten, es ist keine Ausnehmung auf der Verdampfungsfläche vorgesehen, in welcher sich die Schmelze sammeln soll. Das Lokalisieren der Schmelze erfolgt damit einzig und allein durch die unterschiedliche Benetzungsneigung bei unterschiedlicher Temperatur, oder einfach gesagt dadurch, daß die Randzone kälter ist und damit keine Benetzungsneigung aufweist. Besonders vorteilhaft läßt sich diese Ausführungsform mit dem zuvor erwähnten, flachen Dreieck verwirklichen, bei welchem das Verhältnis von Breite zu Höhe z. B. 30 mm : 10 mm beträgt.

Die Erfindung wird nachfolgend anhand bevorzugter Ausführungsbeispiele unter Bezugnahme auf die Zeichnung erläutert. In der Zeichnung zeigen:
Fig. 1 eine schmematische Schnittdarstellung des gesamten Verdampfers;
Fig. 2 eine Ausführungsform einer Einspannung eines Verdampferschiffchens für das in Fig. 1 dargestellte Ausführungsbeispiel;
Fig. 3-5 perspektivische Darstellungen von Ausführungsformen des Verdampferschiffchens.

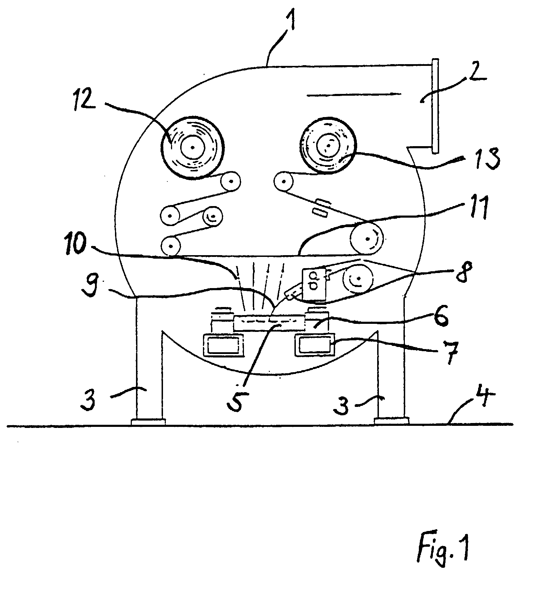

Der in Fig. 1 dargestellte Verdampfer ist mit einem Gehäuse 1 versehen, welches mittels eines Kanals 2 an eine Unterdruckquelle angeschlossen ist, so daß im Inneren des Gehäuses 1 ein Unterdruck herrscht. Der Verdampfer kann mittels Standfüßen 3 auf dem Boden 4 aufstehen. Ein Verdampferschiffchen 5, welches gemäß diesem Ausführungsbeispiel aus Titandiborid ausgebildet ist, sowie mit einer isolierenden Phase aus Bornitrid bzw. Bornitrid plus Aluminiumnitrid ausgebildet ist, ist zwischen Einspannbacken 6 so eingespannt, daß ein elektrisch leitender Kontakt zu den wassergekühlten, elektrischen Leitern 7 jeweils im Endbereich in Längsrichtung gesehen des Verdampferschiffchens hergestellt wird.

Mittels einer Zuführdüse 8 wird Aluminiumdraht 9 auf das Verdampferschiffchen 5 geführt, wo der Aluminiumdraht schmilzt und schließlich in Richtung der Pfeile 10 nach oben verdampft, wo die zu bedampfende Folie 11 entlanggeführt wird. Die Folie 11 ist dabei elektrostatisch derart aufgeladen, daß die von dem Verdampferschiffchen 5 abgedampften Aluminiummoleküle sich auf der Folie 11 niederschlagen, die z.B. eine Kondensatorfolie zum Herstellen eines Wickelkondensators sein kann. Die Folie 11 kann von einer Vorratsrolle 12 abgespult werden, und von einer weiteren Vorratsrolle 13 kann die fertigbedampfte Aluminiumfolie aufgenommen werden.

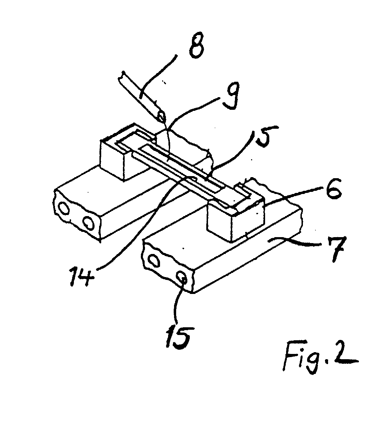

Fig. 2 zeigt die Einspannbacken 6 im Detail, welche das Verdampferschiffchen 5 fest umschließen. In dem Verdampferschiffchen ist eine Kavität 14 ausgebildet, in welche mittels der Drahtzufuhrdüse 8 Aluminiumdraht 9 eingespeist wird. Die Einspannbacken sind gegen die Stirnfläche des Verdampferschiffchens an dessen Enden in Längsrichtung fest angepreßt, so daß die gesamte Stirnfläche des Verdampferschiffchens flächendeckend kontaktiert ist. Die Einspannbacken 6 sind elektrisch leitend mit dem elektrischen Leiter 7 verbunden, welcher gemäß diesem Ausführungsbeispiel aus Kupfer ausgebildet ist. Die Wasserkühlung des Leiters 7 erfolgt über Kanäle 15, durch welche Kühlwasser strömt.In Längsrichtung des Verdampferschiffchens 5 wird eine Lokalisierung der Aluminiumschmelze dadurch erreicht, daß das Verdampferschiffchen 5 in die Einspannbacken 6 eingespannt ist und somit mit dem gekühlten, elektrischen Leiter 7 wärmeleitend verbunden ist, so daß die Endbereiche des Verdampferschiffchens 5 automatisch kühler sind und somit eine geringere Benetzungsneigung aufweisen, wodurch die Aluminiumschmelze in Längsrichtung des Verdampferschiffchens 5 lokalisiert wird.

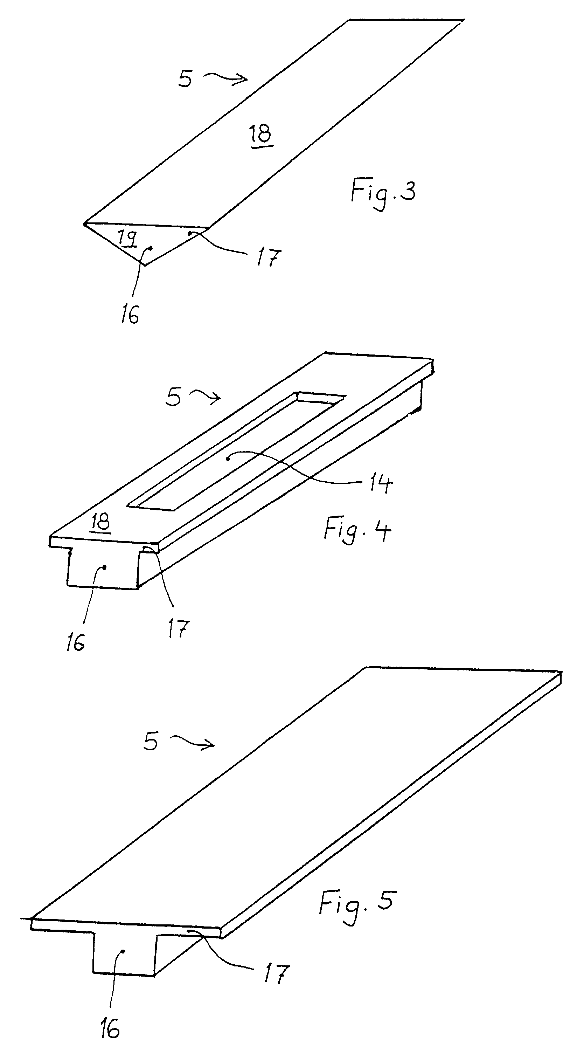

In den Fig. 3-5 sind Ausführungsbeispiele dargestellt, bei welchen das gesamte Verdampferschiffchen aus einem homogenen Material hergestellt ist, der Querschnitt aber so gestaltet ist, daß in den Randzonen 17 eine stärkere Abstrahlung als in der Mittelzone 16 stattfindet. Im einzelnen zeigt das in Fig. 3 dargestellte Verdampferschiffchen den Querschnitt eines flachen Dreiecks, wobei der Maßstab 1 : 1 gewählt wurde. Der Querschnitt, d.h. die Verdampfungsfläche 18, ist 30 mm breit, während die Höhe des Dreiecks 10 mm beträgt oder in anderen Worten die Scheitelkante des Dreieckquerschnitts in einem Abstand von 10 mm parallel zu der Verdampfungsfläche 18 verläuft. Bei einem derartigen Querschnitt erfolgt die Einspannung in die Einspannbacken 6 derart, daß der Querschnitt über seine gesamte Fläche kontaktiert ist, oder in anderen Worten ausgedrückt, die Einspannbacken 6 fest gegen die Stirnflächen 19 des Verdampferschiffchens 5 angepreßt sind. Selbstverständlich kann das Verdampferschiffchen nach Fig. 5 auch mit einer Kavität 14 versehen sein. In dem in Fig. 3 dargestellten Ausführungsbeispiel wurde jedoch auf die Kavität 14 vollständig verzichtet und die Lokalisierung der Aluminiumschmelze erfolgt ausschließlich durch die unterschiedlichen Temperaturbereiche an den Enden des Verdampferschiffchens aufgrund der durch die Einspannbacken 6 hervorgerufenen Wärmeableitung, und gemäß der bevorzugten Ausführungsform entlang der Längskante des Verdampferschiffchens durch die querschnittsbedingte, stärkere Abstrahlung in der Randzone 17.

Eine entsprechende Gestaltung des Querschnitts ist in den Fig. 4 und 5 dargestellt, wobei der Querschnitt "T"-förmig gestaltet ist, wobei die Verdampfungsfläche 18 bei dem Ausführungsbeispiel in Fig. 4 mit einer Kavität 14 versehen ist, während bei der Ausführungsform nach Fig. 5 ähnlich der in Fig. 3 dargestellten Ausführungsform die Lokalisierung der Schmelze allein durch die stärkere Abstrahlung von Wärme in den Randzonen 17 erreicht wird. Die Darstellung nach den Fig. 4 und 5 ist ebenfalls in einem Maßstab 1:1, wobei die Länge der Verdampferschiffchen 5 wie auch bei dem in Fig. 3 dargestellten Ausführungsbeispiel 250 mm betragen kann. Bei dem in Fig. 4 dargestellten Ausführungsbeispiel ist die Breite des "Stegs" des "T"-förmigen Profils 19 mm, während die Gesamtbreite des Profils 28 mm beträgt, sowie dessen Höhe 11 mm. Die Dicke der "Schenkel" des "T"-förmigen Profils beträgt in diesem Ausführungsbeispiel 2 mm. Entsprechend zeigt Fig. 5 ein solches Querschnittsprofil des Verdampferschiffchens, bei welchem der "Steg" des "T"-förmigen Querschnittsprofils eine Breite von 15 mm aufweist, während die Gesamtbreite des Querschnittsprofils 47 mm beträgt. Die "Schenkel" des "T"-förmigen Querschnittsprofils weisen bei diesem Ausführungsbeispiel eine Dicke von 1,5 mm auf. Die Gesamthöhe des Querschnittsprofils beträgt 12 mm.

Zu dem in Fig. 3 dargestellten Ausführungsbeispiel bleibt noch nachzutragen, daß neben der Lokalisierung der Schmelze allein aufgrund einer höheren Wärmeabstrahlung in der Randzone 17 auch noch insgesamt eine Energieeinsparung gegenüber Rechteckquerschnitten erreicht wird, weil die schräg nach unten gerichteten Abstrahlflächen des dreieckförmigen Querschnitts, welche für die Abstrahlungsverluste hauptsächlich verantwortlich sind, im Vergleich zum sich aufheizenden Verdampferschiffchen-Volumen des dreieckförmigen Querschnitts kleiner als die Gesamtfläche der beiden seitlichen und der einen nach unten gerichteten Abstrahlfläche bei rechteckförmigen Querschnitten ist, welche bei derartigen Querschnitten für den Großteil der Strahlungsverluste verantwortlich sind.

Nachfolgend werden einige Beispiele und Vergleichsbeispiele erläutert:

### Beispiel 1 und Vergleichsbeispiel 1

Es wurde ein Rechteckprofil-Verdampferschiffchen mit der Abmessung 12 x 19 x 250 mm (Standardmaß) mit einem geometrisch neu gestalteten Verdampfer entsprechend Figur 4 mit den Abmessungen 11 x 19 im Kernbereich und zusätzlich Überständen von 2 x 4,5 mm bei gleicher Länge verglichen. Bei dieser Gestaltung wurde berücksichtigt, daß der Gesamtquerschnitt der beiden Verdampferschiffchen der gleiche war.

Beim Vergleich der beiden Verdampferschiffchen konnte bereits beim Erhitzen klar erkannt werden, daß die verdünnten Seitenränder wegen der höheren Abstrahlung eine deutlich niedrigere Temperatur im Bereich der verdünnten Seiten aufwiesen.

Nachdem das Aluminium drahtförmig einerseits auf das herkömmliche, mit einer Kavität versehenen Rechteckprofil, andererseits auf das mit gleicher Temperatur betriebene Verdampferschiffchen nach Fig. 4 in den Mittelbereich zugeführt wurde, zeigte sich innerhalb kurzer Zeit, daß die Ausbreitung des Aluminiumbades im Falle des Verdampferschiffchen mit herkömmlichem Rechteckquerschnitt in Querrichtung zum Überlaufen des Aluminiums an den Seiten führte und zur seitlichen Verdampfung des Aluminiums. Hingegen wurde im Falle des neu gestalteten Verdampferschiffchens nach Fig. 4 dieser Effekt nicht festgestellt, vielmehr erfolgte eine gerichtete Benetzung in axialer Richtung bei gleichzeitig gerichteter Abdampfung in vertikaler Richtung.

### Vergleichsbeispiel 2

Nachdem im Beispiel 1 selbstverständlich die aktive Verdampfungsfläche unterschiedliche Breiten-Längen-Verhältnisse aufwies (im Fall des Standardverdampfers mit Rechteckquerschnitt 19 x 12 x 250 mm, im Fall des in Fig. 4 dargestellten, konstruktiv neu gestalteten Verdampfers 28 x 11 x 250 mm), liegt der Verdacht nahe, daß aufgrund der höheren Breite des Verdampferschiffchens ein Überlaufen des Aluminiumbades in seitliche Richtung unterbunden wurde. Aus diesem Grunde wurde in einem weiteren Versuch ein Verdampferschiffchen mit Rechteckquerschnitt gleicher Breite und gleicher Querschnittsfläche mit den Abmessungen 28 x 8,1 mm hergestellt und wiederum mit dem konstruktiv neu gestalteten Verdampferschiffchen nach Fig. 4 verglichen. Dabei zeigte sich wie im ersten Fall, daß das Verdampferschiffchen mit Rechteckprofil eine homogene Temperaturverteilung über den Querschnitt zeigte. Nach der Benetzung durch Aluminium war ebenfalls zunächst zu beobachten, daß das Aluminiumbad sich sehr schnell auch in seitlicher Richtung ausbreitete und über die Ränder überlief, so daß auch bei dem breiteren Verdampfer eine, wenn auch etwas geringere verglichen mit dem ersten Vergleichsbeispiel, so doch merklich vorhandene seitliche Verdampfung des Aluminiums zu beobachten war.

### Beispiel 2

Um den Effekt der Abstrahlung noch deutlicher zu charakterisieren, wurde ein Verdampferschiffchen mit den Abmessungen 12 x 15 mm im Kernbereich ("Steg") seitlichen Überständen ("Schenkel") von 1,5 x 16 mm je Seite und einer Länge von 250 mm hergestellt, wie es in Fig. 5 dargestellt ist. Beim Betreiben dieses Verdampfers unter gleichen Bedingungen wie im Beispiel 1 wurde beobachtet, daß durch die axial zentrale Heizung eine ideale Ausbreitung des Aluminiumbades in axialer Richtung zu beobachten war, und ein Überlaufen zu den Rändern total unterbunden wurde, wobei sogar nicht benetzte Zonen entlang der Ränder entstanden sind. Das Verhältnis des Aluminiumbades Breite zu Länge betrug 1 : 9, während das Verhältnis bei dem in Figur 4 dargestellten Verdampferschiffchen 1: 11 betrug. Im Gegensatz dazu betrug das Benetzungsverhältnis nach den Vergleichsbeispielen 1 bzw. 2 mit dem 12 x 19 Rechteckquerschnitt nur 1: 4,5 mm und mit dem 28 x 8,1 nur 1:5 mm, wodurch sich abgesehen von dem Überlaufen über die Längskanten der Verdampferschiffchen nach den Vergleichsbeispielen auch eine wesentlich ungünstigere Flächenbenetzung der Verdampfungsfläche und damit eine verringerte Verdampfungsleistung ergibt.

### Beispiel 3 und Vergleichsbeispiel 3

Neben den im Beispiel 1 und 2 beschriebenen prinzipiellen Geometrien wurde auch ein Verdampferschiffchen mit V-förmigem Querschnitt untersucht. Die Breite des Verdampferschiffchens betrug dabei 30 mm, die maximale Dicke 10 mm und die Länge 150 mm. Ein derartiges Verdampferschiffchen ist in Fig. 3 dargestellt. Auch bei diesem Verdampferschiffchen konnte der Effekt der erhöhten Verlustleistung durch Strahlungsverluste an den Rändern eine Lokalisierung des Aluminiumbades erwirken. Das Breiten-Längen-Verhältnis des Aluminiumbades betrug 1: 4,5 im Gegensatz zu 1 : 2,4 bei einem Standardverdampfer mit rechteckigem Querschnitt von 10 x 30 mm bei gleicher Länge von 150 mm. Insgesamt war das Verdampferschiffchen nach Fig. 3 hinsichtlich einer verringerten Gesamt-Strahlungsverlustleistung dem Referenzprofil mit einem 10 x 30 Rechteckquerschnitt deutlich überlegen, so daß die Verwendung des Dreiecksprofils nach Fig. 5 zu einer etwa 25%-igen Energieeinsparung allein aufgrund verringerter Strahlungsverluste führte. Hinzu kommen die Einergieeinsparungen aufgrund des geringeren, aufzuheizenden Verdampferschiffchen-Volumens.

## Patentansprüche

1. Verfahren zum Verdampfen von Metall, insbesondere von Aluminium bzw. von dessen Legierungen, auf einem keramischen, homogenen, widerstandsbeheizten Verdampferschiffchen mit einer im Vergleich zur Längsausdehnung geringen Querausdehnung, mit den Verfahrensschritten Aufheizen des Verdampferschiffchens auf die Verdampfungstemperatur des Metalls durch Hindurchführen eines homogen über den Querschnitt des Verdampferschiffchens verteilten, elektrischen Stromflusses, und Zuführen von Metall auf das Verdampferschiffchen, um das Metall zunächst zu schmelzen und dann zu verdampfen, gekennzeichnet durch den Verfahrensschritt des selektiven Abführens von Wärme durch Abstrahlen von Längskanten des Verdampferschiffchens, derart, daß in dessen Mitte eine Zone höherer Temperatur als an dessen Rändern ausgebildet wird, welche so eine deutlich niedrigere Temperatur aufweisen, so daß eine gerichtete Benetzung in axialer Richtung bei gleichzeitig gerichteter Abdampfung in vertikaler Richtung erfolgt, so daß ein seitliches Überlaufen der Schmelze über die Längskanten verhindert wird.

2. Verfahren nach Anspruch 1, dadurch gekennzeichnet, daß das selektive Abführen von Wärme durch Wärmeleitung zusätzlich zum Abstrahlen von Wärme erfolgt.

3. Keramisches, widerstandsbeheiztes Verdampferschiffchen mit einer im Vergleich zur Längsausdehnung geringen Querausdehnung, wobei das Querschnittsprofil des Verdampferschiffchens (5) eine derartige Form aufweist, daß das Verhältnis von Oberfläche des Verdampferschiffchens (5) im Verhältnis zu dem davon umschlossenen Volumen in Querrichtung von der Mitte zum Rand hin zunimmt und der spezifische Widerstand des Verdampferschiffchens über den Querschnitt homogen ist, dadurch gekennzeichnet, daß das Querschnittsprofil im wesentlichen die Form eines flachen Dreiecks aufweist, wobei das Verhältnis von Breite zu Höhe wenigstens 2:1 beträgt.

4. Verdampferschiffchen nach Anspruch 3, dadurch gekennzeichnet, daß das Verhältnis von Breite zu Höhe 30 mm zu 10 mm beträgt.

5. Keramisches, widerstandsbeheiztes Verdampferschiffchen mit einer im Vergleich zur Längsausdehnung geringen Querausdehnung, wobei das Querschnittsprofil des Verdampferschiffchens (5) eine derartige Form aufweist, daß das Verhältnis von Oberfläche des Verdampferschiffchens (5) im Verhältnis zu dem davon umschlossenen Volumen in Querrichtung von der Mitte zum Rand hin zunimmt und der spezifische Widerstand des Verdampferschiffchens über den Querschnitt homogen ist, dadurch gekennzeichnet, daß das Querschnittsprofil im wesentlichen T-förmig ausgebildet ist.

6. Verdampferschiffchen nach einem der Ansprüche 3 bis 5, dadurch gekennzeichnet, daß das Verdampferschiffchen (5) eine vollständig ebene, obere Verdampfungsfläche (18) aufweist.

## Claims

1. A method for vaporizing metal, and in particular aluminum or its alloys, on the surface of a homogeneous, resistance-heated ceramic vaporizer boat having a small cross dimension as compared to its longitudinal dimension, comprising the steps
heating the vaporizer boat to the evaporation point of the metal by passing through the vaporizer boat an electric current which is homogeneous across the cross section of the vaporizer boat, and
supplying metal to the vaporizer boat so that the metal first melts and then vaporizes,
characterized by the step of
selectively dissipating heat from longitudinal edges of the vaporizer boat by thermal radiation so that in the center of the vaporizer boat a portion of higher temperature as compared to its edges is formed with the edges thus having a significantly lower temperature, so that a targeted wetting in the axial direction with simultaneous targeted vaporization in the vertical direction takes place and the melt is prevented from flowing laterally over the longitudinal edges.

2. A method as claimed in claim 1, characterized in that heat is selectively dissipated by thermal conduction in addition to its dissipation by thermal radiation.

3. A resistance-heated, ceramic vaporizer boat having a small cross dimension as compared to its longitudinal dimension, with the cross section of the vaporizer boat (5) being formed such that the relation between the surface area of the vaporizer boat (5) relative to the volume enclosed by this surface area increases in the transverse direction from the center towards the edges, and that the resistivity of the vaporizer boat is homogeneous across the cross-section,
characterized in that
the cross-sectional form is substantially that of a flat triangle, with the width-to-height ratio being at least 2 : 1.

4. A vaporizer boat as claimed in claim 3, characterized in that the width-to-heigth ratio is 30 mm : 10 mm.

5. A resistance-heated, ceramic vaporizer boat having a small cross dimension as compared to its longitudinal dimension, with the cross section of the vaporizer boat (5) being formed such that the relation between the surface area of the vaporizer boat (5) relative to the volume enclosed by this surface area increases in the transverse direction from the center towards the edges, and that the resistivity of the vaporizer boat is homogeneous across the cross-section,
characterized in that
the cross-sectional form is substantially T-shaped.

6. Vaporizer boat according to anyone of the claims 3 to 5, characterized in that the vaporizer boat (5) comprises a completely even upper evaporation surface (18).

## Revendications

1. Procédé pour vaporiser un métal, notamment de l'aluminium ou des alliages d'aluminium, dans une nacelle homogène céramique d'un dispositif de vaporisation, chauffée par résistance et possédant une étendue transversale comparativement faible par rapport à son étendue longitudinale, comprenant les étapes de procédé incluant un chauffage de la nacelle de vaporisation à la température de vaporisation du métal par circulation d'un flux de courant électrique réparti de façon homogène dans la section transversale de la nacelle de vaporisation et amenée d'un métal sur la nacelle de vaporisation, pour tout d'abord faire fondre le métal, puis le vaporiser, caractérisé par l'étape de procédé consistant à évacuer de façon sélective la chaleur par rayonnement à partir de bords longitudinaux de la nacelle de vaporisation de telle sorte qu'au milieu de cette nacelle est formée une zone, dont la température est plus élevée qu'au niveau des bords de la nacelle, qui possèdent une température nettement plus faible de telle sorte qu'il se produit un mouillage dirigé dans la direction axiale avec une vaporisation simultanément dirigée dans la direction verticale, de sorte qu'un débordement latéral de la masse fondue au-delà des bords longitudinaux est empêché.

2. Procédé selon la revendication 1, caractérisé en ce que l'évacuation sélective de la chaleur est exécutée par conduction thermique en plus de l'évacuation de la chaleur par rayonnement.

3. Nacelle céramique de vaporisation, chauffée par résistance et possédant une étendue transversale faible par rapport à son étendue longitudinale, et dans laquelle le profil en coupe transversale de la nacelle de vaporisation (5) possède une forme telle que le rapport de la surface de la nacelle de vaporisation (5) au volume englobé par cette surface augmente dans la direction transversale, depuis le milieu en direction du bord, et la résistance spécifique de la nacelle de vaporisation est homogène dans la section transversale, caractérisée en ce que le profil en coupe transversale possède essentiellement la forme d'un triangle plat, le rapport de la largeur à la hauteur étant égal à au moins 2:1.

4. Nacelle de vaporisation selon la revendication 3, caractérisée en ce que le rapport de la largeur à la hauteur est de 30 mm à 10 mm.

5. Nacelle céramique de vaporisation, chauffée par résistance et possédant une étendue transversale faible par rapport à son étendue longitudinale, et dans laquelle le profil en coupe transversale de la nacelle de vaporisation (5) possède une forme telle que le rapport de la surface de la nacelle de vaporisation (5) au volume englobé par cette surface augmente dans la direction transversale, depuis le milieu en direction du bord, et la résistance spécifique de la nacelle de vaporisation est homogène dans la section transversale, caractérisée en ce que le profil en coupe transversale est réalisé essentiellement avec une forme en T.

6. Nacelle de vaporisation selon l'une des revendications 3 à 5, caractérisée en ce que la nacelle de vaporisation (5) possède une surface supérieure de vaporisation (18) entièrement plane.
